# EUROPÄISCHE PATENTSCHRIFT

(11) **EP 2 709 224 B1**
(45) Veröffentlichungstag und Bekanntmachung des Hinweises auf die Patenterteilung: **17.01.2018**
(21) Anmeldenummer: 12306106.1
(22) Anmeldetag: 14.09.2012
(51) Int. Cl.: H02G 15/34, H01B 12/06, H01R 4/68

(54) **Anordnung zum elektrisch leitenden Verbinden von zwei supraleitfähigen Leitern**
Assembly for electrically connecting two superconductive conductors
Agencement de connexion électrique de deux fils supraconducteurs

(43) Veröffentlichungstag der Anmeldung: 19.03.2014
(73) Patentinhaber: Nexans, 92400 Courbevoie (FR)
(72) Erfinder: Dr. Stemmle, Mark, 30625 Hannover (DE); Dr. Soika, Rainer, 30559 Hannover (DE)
(74) Vertreter: Döring, Roger

(56) Entgegenhaltungen:
- EP-A1- 1 158 543
- EP-A1- 2 728 592
- EP-A2- 0 827 217
- JP-A- 2007 266 149
- JP-A- 2011 238 510
- US-A1- 2010 022 396
- US-B1- 7 071 148

## Beschreibung

Die Erfindung bezieht sich auf eine Anordnung umfassend zwei supraleitfähige, bandförmige elektrische Leiter gemäß dem Oberbegriff des Patentanspruchs 1.

Eine solche Anordnung geht beispielsweise aus der Veröffentlichung der US-Firma AMSC aus dem Jahre 2010, "Guidelines for Hand-Assembled Splicing of Amperium Wire", Seiten 1 bis 7 hervor.

Für supraleitfähige Leiter geeignete Materialien sind beispielsweise oxidische Materialien auf Basis seltener Erden (ReBCO), insbesondere YBCO (Yttrium-Barium-Kupfer-Oxid), oder BSCCO (Wismut-Strontium-Kalzium-Kupfer-Oxid). Auch Magnesiumdiborid ist als supraleitfähiges Material bekannt. Supraleitfähige Leiter aus den angegebenen Materialien können in relativ großen Längen hergestellt werden. Zum Aufbau von supraleitfähigen Kabeln werden die Leiter beispielsweise um einen Kern oder eine andere Unterlage herumgewickelt. Für eine kontinuierliche Fertigung eines supraleitfähigen Kabels wird ein entsprechend langer Leiter benötigt. Es kann dann erforderlich sein, dass zwei oder mehr Längen des supraleitfähigen Leiters elektrisch leitend miteinander verbunden werden müssen. Eine solche Verbindung von zwei Abschnitten eines Leiters muß auch dann hergestellt werden, wenn aus einem Leiter eine schadhafte Stelle herausgeschnitten werden muß oder wenn der Leiter während der Fertigung reißt.

Aus der US 2010/0022396 A1 geht eine Verbindungsstelle von zwei supraleitfähigen Leitern hervor, die mit laminiertem Aufbau in mehreren Schichten eingebettet sind. Die stirnseitigen Enden der Leiter sind verjüngt und zwischen beiden Leitern ist ein Verbindungselement mit ebenfalls laminiertem Aufbau angebracht. Die beiden laminierten Gebilde sind oben und unten durch je einen Streifen aus elektrisch leitendem Material verbunden, der auch auf dem Verbindungselement aufliegt.

Die EP 0 827 217 A2 beschreibt eine Verbindungsstelle zwischen zwei supraleitfähigen Leitern mit laminiertem Aufbau, die mit ihren Stirnseiten in einer Verbindungsstelle aneinander liegen. Die beiden Leiter sind im Bereich der Verbindungsstelle durch einen an denselben anliegenden Streifen zusammengehalten, der einen gleichen Aufbau wie die beiden Leiter hat.

Die US 7,071,148 B1 beschreibt eine Verbindungsstelle zwischen zwei supraleitfähigen Bändern. Jedes Band besteht aus einem Träger, einer auf demselben liegenden Pufferschicht, einer darauf angebrachten Schicht aus supraleitfähigem Material, einer darüber angeordneten Metallschicht und einer auf derselben liegenden stabilisierenden Schicht. Zum Verbinden der beiden Bänder wird an den Enden derselben die stabilisierende Schicht entfernt. In der dadurch entstandenen Lücke wird ein Verbindungsstück angeordnet und mit der Metallschicht verlötet. Das Verbindungsstück ist rechteckig ausgeführt und paßt genau in die Lücke zwischen den beiden Bändern.

Gemäß der EP 1 158 543 A1 werden zwei Bänder aus supraleitfähigem Material mit ihren Enden aufeinandergelegt und unter Zwischenschaltung von Lötmaterial miteinander verbunden. Die Enden der Bänder können geradlinig verlaufen, sie können aber auch abgeschrägt sein oder spitz zulaufen.

Die EP 2 728 592 A1 betrifft die Verbindung von zwei supraleitfähigen Leitern, die durch einen Spalt voneinander getrennt sind. Der Spalt zwischen den beiden Leitern ist vorgesehen, damit keine zu hohe Erwärmung entstehen kann. Für die Verbindung des ersten supraleitfähigen Leiters und des zweiten supraleitfähigen Leiters wird ein dritter supraleitfähiger Leiter eingesetzt. Es soll dadurch die Qualität der elektrischen Verbindung so beschaffen sein, dass eine stabile Supraleitfähigkeit erhalten wird. Alle drei Leiter haben den gleichen mehrschichtigen Aufbau. Der den ersten und den zweiten Leiter verbindende dritte Leiter soll in bevorzugter Ausführungsform schmaler als die beiden zu verbindenden Leiter sein. Er kann mit zunehmender Entfernung von der Verbindungsstelle auch verjüngt sein.

Eine Anordnung, wie sie eingangs erwähnt ist, geht beispielsweise aus der ebenfalls eingangs angeführten Veröffentlichung der Firma AMSC für supraleitfähige Leiter hervor, bei denen das supraleitfähige Material auf einer Pufferschicht angebracht ist, die ihrerseits auf einer Trägerschicht liegt. Es können demnach zwei supraleitfähige Leiter dadurch miteinander verbunden werden, daß der eine um 180° gedreht und mit seiner supraleitfähigen Schicht auf die des anderen Leiters aufgelegt wird. Die beiden Leiter werden dann miteinander verlötet. Eine andere Möglichkeit besteht darin, die beiden Leiter mit ihren Stirnflächen aneinander zu positionieren und einen rechteckigen Streifen aus supraleitfähigem Material, der zumindest annähernd die gleiche Breite wie die beiden Leiter hat, auf dieselben aufzulöten. In beiden Fällen ist
die Verbindungsstelle zwischen den beiden Leitern relativ steif, so daß die Biegbarkeit des Leiters verschlechtert wird.

Der Erfindung liegt die Aufgabe zugrunde, die eingangs beschriebene Anordnung so zu gestalten, daß die Biegbarkeit des supraleitfähigen Leiters an Verbindungsstellen verbessert wird.

Diese Aufgabe wird entsprechend den kennzeichnenden Merkmalen des Patentanspruchs 1 gelöst.

Die beiden Leiter sind an ihrer Verbindungsstelle durch den Streifen ausreichend fest verbunden, weil derselbe im Bereich der Verbindungsstelle etwa die gleiche Breite wie die Leiter hat. Die Biegbarkeit des durch den Streifen hergestellten, einteiligen Leiters wird durch dessen auf beiden Seiten der Verbindungsstelle gegebene Verjüngung wesentlich verbessert, weil bedingt durch die Verjüngungen gegebenenfalls weniger Material gebogen werden muß. Da der Streifen mit zunehmender Entfernung von der Verbindungsstelle infolge der Verjüngungen zunehmende Abstände von den Seitenkanten der beiden miteinander verbundenen Leiter hat, ist außerdem die Gefahr von Beschädigungen von Schichten verringert, die beispielsweise bei der Herstellung eines supraleitfähigen Kabels um den Leiter herumgeformt werden.

Mit besonderem Vorteil ist der Streifen mit konischem Verlauf symmetrisch zur Mittellinie der Leiter verjüngt. Seine Enden sind vorzugsweise abgerundet. Die Randbereiche des Streifens sind außerdem dünner als der zentrale Bereich desselben ausgeführt.

Ein Ausführungsbeispiel des Erfindungsgegenstandes ist in den Zeichnungen dargestellt. Es zeigen:
Fig. 1 in schematischer Darstellung eine Seitenansicht der Anordnung nach der Erfindung im Schnitt.
Fig. 2 eine Draufsicht auf die Anordnung nach Fig. 1.

Die folgende Beschreibung bezieht sich stellvertretend auch für Leiter aus allen anderen supraleitfähigen Materialien auf supraleitfähige Leiter der sogenannten 2. Generation mit beispielsweise YBCO als supraleitfähigem Material. Dieses Material ist entsprechend der eingangs erwähnten Veröffentlichung der Firma AMSC beispielsweise auf einem Unterbau aufgebracht, der zumindest aus einer Trägerschicht und einer darauf liegende Pufferschicht besteht. Das supraleitfähige Material ist auf der Pufferschicht angebracht. Es kann zusätzlich mit einer dünnen Schutzschicht aus elektrisch leitendem Material, wie beispielsweise Silber, abgedeckt sein. Über dieser Schicht kann auch noch eine weitere elektrisch leitende Schicht angebracht sein, die beispielsweise aus Kupfer besteht.

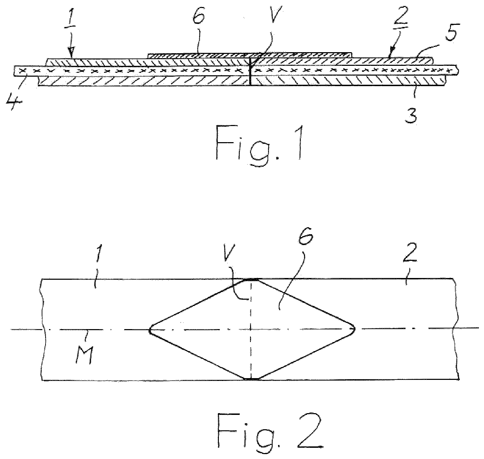

In Fig. 1 ist eine Verbindungsstelle V zwischen zwei supraleitfähigen, bandförmigen Leitern 1 und 2 gezeigt, die mit Vorteil die gleiche Breite haben und mit ihren Stirnseiten aneinander liegen. Die beiden Leiter 1 und 2 sollen zumindest annähernd gleich breit sein. Jeder der beiden Leiter 1 und 2 weist eine Trägerschicht 3 auf, bei der es sich beispielsweise um ein biaxial texturiertes Band aus Nickel, Kupfer oder Eisen handeln kann. Auf der Trägerschicht 3 ist jeweils eine Pufferschicht 4 angebracht, die beispielsweise aus Kupfer oder Silber bestehen kann. Die auf der Pufferschicht 4 liegende Schicht 5 aus supraleitfähigem Material besteht beispielsweise aus YBCO. Über der Schicht 5 können - wie bereits erwähnt - eine zusätzliche elektrisch leitende Schutzschicht und eine weitere ebenfalls elektrisch leitende Schicht angebracht sein.

Die beiden Leiter 1 und 2 sind durch einen Streifen 6 aus supraleitfähigem Material fest miteinander verbunden. Dazu ist der Streifen 6, dessen Gestaltung beispielsweise aus Fig. 2 hervorgeht, mit den beiden Leitern 1 und 2 verlötet. Er kann grundsätzlich den

gleichen Aufbau haben, wie die beiden miteinander zu verbindenden Leiter 1 und 2. Es kann aber auch ein anders aufgebauter Streifen 6 aus einem beliebigen supraleitfähigen Material eingesetzt werden.

Der Streifen 6 hat im dargestellten Ausführungsbeispiel gemäß Fig. 2 im Bereich der Verbindungsstelle V die gleiche Breite wie die Leiter 1 und 2. Er soll an dieser Stelle zumindest annähernd so breit wie die Leiter 1 und 2 sein. Von der Verbindungsstelle V
wegweisend ist der Streifen 6 auf beiden Seiten verjüngt, und zwar mit Vorteil mit konischem Verlauf symmetrisch zur Mittellinie M der beiden Leiter 1 und 2. In bevorzugter Ausführungsform ist der Streifen 6 entsprechend der zeichnerischen Darstellung an seinen beiden Enden abgerundet. Der Streifen 6 kann außerdem in seinen Randbereichen, vorzugsweise mit kontinuierlichem Übergang, dünner ausgeführt sein als in seinem zentralen Bereich, der im Montagezustand im Bereich der Mittellinie M der beiden Leiter 1 und 2 liegt. Die dünnen Randbereiche erstrecken sich dann bis in die "Spitzen" der Verjüngungen des Streifens 6, die dadurch ebenfalls dünner sind.

## Patentansprüche

1. Anordnung umfassend zwei supraleitfähige, bandförmige elektrische Leiter (1,2) mit zumindest annähernd gleicher Breite und einen Streifen (6) aus supraleitfähigem Material, bei welcher die beiden Leiter (1,2) an einer Verbindungsstelle (V) mit ihren Stirnseiten aneinander liegen, bei welcher der Streifen (6) aus supraleitfähigem Material zum elektrisch leitenden Verbinden der beiden Leiter (1,2) auf beide Leiter (1,2) aufgelegt und mit denselben verlötet ist, wobei sich der Streifen (6) unter Abdeckung der Verbindungsstelle (V) bis über beide Leiter (1,2) erstreckt, **dadurch gekennzeichnet,**
- **dass** der Streifen (6) nur im Bereich der Verbindungsstelle (V) zwischen den beiden Leitern (1,2) zumindest annähernd die gleiche Breite wie dieselben hat und auf beiden Seiten der Verbindungsstelle (V) von derselben wegweisend in seiner Breite verjüngt ist, und
- **dass** der Streifen (6) in seinen Randbereichen, vorzugsweise mit kontinuierlichem Übergang, dünner ausgeführt ist als in seinem im Bereich der Mittellinie (M) der Leiter (1,2) liegenden zentralen Bereich.

2. Anordnung nach Anspruch 1, **dadurch gekennzeichnet, dass** die Enden des Streifens (6) abgerundet sind.

3. Anordnung nach Anspruch 1 oder 2, **dadurch gekennzeichnet, dass** der Streifen (6) mit vorzugsweise konischem Verlauf symmetrisch zur Mittellinie (M) der Leiter (1,2) verjüngt ist.

## Claims

1. An arrangement consisting of two superconductive, ribbon-like electric conductors (1,2) having approximately the same width and a strip (6) of superconductive material, in which the two conductors (1,2) abut to each other with their end faces in a connecting point (V) and in which the strip (6) of superconductive material for the connection of the two conductors (1,2) is put onto and soldered to the same, wherein the strip (6) extends beyond both conductors (1,2) so as to cover the connecting point (V), **characterized in**
- **that** the strip (6) of superconductive material has, only in the area of the connecting point (V) between the two conductors (1,2), at least approximately the same width as the same and is on both sides of the connecting point (V) narrowed in its width facing away from the connecting point (V), and
- **that** the strip (6) is thinner in its border areas than in its central area located in the area of the center line (M) of the conductor (1,2), preferably with a continuous transition.

2. Arrangement according to claim 1, **characterized in that** the ends of the strip (6) are rounded.

3. Arrangement according to claim 1 or 2, **characterized in that** the strip (6) runs symmetrically to the middle line (M) of the conductors (1,2), preferably with a conical pattern.

## Revendications

1. Ensemble comprenant deux conducteurs électriques (1, 2) supraconducteurs en forme de rubans ayant au moins approximativement la même largeur et une bande (6) en matériau supraconducteur, dans lequel les deux conducteurs (1, 2) sont adjacents l'un à l'autre par leurs extrémités avant en un point de connexion (V) où la bande (6) en matériau supraconducteur est appliquée aux deux conducteurs (1, 2) et est soudée à ceux-ci pour la connexion électriquement conductrice des deux conducteurs (1, 2), dans lequel la bande (6) s'étend jusqu'au-dessus des deux conducteurs (1, 2) en recouvrant le point de connexion (V), **caractérisé en ce**
- **que** la bande (6) n'a au moins approximativement la même largeur que les deux conducteurs (1, 2) que dans la zone du point de connexion (V) entre ceux-ci, et sa largeur diminue sur les deux côtés du point de connexion (V) lorsqu'on s'éloigne de celui-ci,
- la bande (6) est réalisée, dans sa zone de bord, de manière à être plus mince, de préférence avec une transition continue, que dans la zone centrale située dans la zone de la ligne médiane (M) des conducteurs (1, 2).

2. Ensemble selon la revendication 1, **caractérisé en ce que** les extrémités de la bande (6) sont arrondies.

3. Ensemble selon la revendication 1 ou 2, **caractérisé en ce que** la bande (6) est biseautée symétriquement par rapport à la ligne médiane (M) du conducteur (1, 2) avec une forme de préférence conique.
